Europäisches Patentamt

European Patent Office

Office européen des brevets

(19)

(11) Veröffentlichungsnummer: **0 106 190 B1**

(12) **EUROPÄISCHE PATENTSCHRIFT**

(45) Veröffentlichungstag der Patentschrift:
07.01.87

(21) Anmeldenummer: **83109276.2**

(22) Anmeldetag: **19.09.83**

(51) Int. Cl.⁴: **H 03 F 3/45**

(54) **Verstärker mit gleichspannungsgekoppelten Transistorstufen.**

(30) Priorität: **21.09.82 DE 3234901**

(43) Veröffentlichungstag der Anmeldung:
**25.04.84 Patentblatt 84/17**

(45) Bekanntmachung des Hinweises auf die Patenterteilung:
**07.01.87 Patentblatt 87/2**

(84) Benannte Vertragsstaaten:
**AT BE CH DE FR GB IT LI NL SE**

(56) Entgegenhaltungen:
**DE - A - 1 944 027
DE - A - 2 633 952
US - A - 3 894 290**

**IEEE JOURNAL OF SOLID-STATE CIRCUITS, Band SC-15, Nr. 2, April 1980 M.-G. YI "Common-mode rejection ratio of differential amplifiers", Seiten 214-221 NTZ, Band 19, Nr. 2, Februar 1966 G. MEYER-BRÖTZ et al. "Zum Problem der Gleichtaktunterdrückung bei Transistor-Differenz-Verstärkern", Seiten 65-69**

(73) Patentinhaber: **Siemens Aktiengesellschaft Berlin und München, Wittelsbacherplatz 2, D-8000 München 2 (DE)**

(72) Erfinder: **Narjes, Ferdinand, Ing. grad., Tölzer Strasse 41, D-8000 München 70 (DE)**

## Beschreibung

Die Erfindung bezieht sich auf einen wie im Oberbegriff des Patentanspruches 1 angegebenen Verstärker mit gleichspannungsgekoppelten Transistoren.

Ein derartiger Verstärker ist bereits aus der DE-A-26 33 952 bekannt. Bei dem bekannten Verstärker sind die beiden Transistorstufen als Kollektorschaltung ohne Gegenkopplung geschaltet. In den Emitterzuführungen sind hochohmige Belastungen angeordnet, um eine hohe Verstärkung zu erzielen. Eine hohe Verstärkung ergibt sich auch dadurch, dass eine an die Differenzeingänge angelegte Differenzspannung voll an der Basis-Emitter-Strecke des weiteren Transistors wirksam wird. Der Differenzverstärker ist für einen Aufbau als integrierte Schaltung und eine Verwendung als Operationsverstärker vorgesehen. Im Hinblick auf die sich ergebenden Phasendrehungen wird ein Phasenkompensationskondensator empfohlen.

Ferner ist aus der Zeitschrift NTZ, Jahrgang 19, Heft 2, Februar 1966, Seiten 65 bis 69 ein Operationsverstärker bekannt, der über äussere Schaltelemente stark gegengekoppelt wird, so dass sich die gewünschte Verstärkung und eine grosse Gleichtaktunterdrückung, in einem gewissen Bereich, weitgehend unabhängig von Versorgungsspannungs- und Temperaturschwankungen einstellt. Hierbei ist die Verstärkung als Quotient der Spannung an den Ausgangsklemmen und der Spannungsdifferenz an den Eingangsklemmen definiert.

Aufgabe der Erfindung ist es, einen Verstärker mit gleichspannungsgekoppelten Transistorstufen mit einem Differenzeingang und mit einem unsymmetrischen Ausgang derart auszubilden, dass er eine definierte Verstärkung hat und bei geringem Bauteileaufwand und kleinem Versorgungsstrom ein gutes Hochfrequenzverhalten aufweist. Insbesondere soll der Verstärker zur Verwendung in Phasenregelkreisen geeignet sein, bei denen besonders hohe Anforderungen an die Regelsteilheit gestellt werden.

Ein Phasenregelkreis, bei dem der die Frequenz des Oszillators steuernde Verstärker einen Differenzeingang und einen unsymmetrischen Ausgang erfordert, geht aus E. Stadler: «Modulationsverfahren», Vogel-Verlag, 2. Aufl., 1980, Seiten 60 bis 62 hervor.

Gemäss der Erfindung wird der Verstärker zur Lösung der gestellten Aufgabe in der im kennzeichnenden Teil des Patentanspruches 1 angegebenen Weise ausgebildet. Dabei ist die Diode für den Konstantstrom in Durchlassrichtung gepolt.

Durch diese Massnahmen ergibt sich der Vorteil, dass sich bei definierter Verstärkung eine grosse Gleichtaktunterdrückung und ein günstiges Hochfrequenzverhalten bei kleiner Stromaufnahme und geringem Bauteileaufwand miteinander vereinigen lassen. Ausserdem lässt sich die mittlere Ausgangsgleichspannung unabhängig von der Verstärkung wählen.

Als Diode kann eine Halbleiterdiode mit geeigneter Kennlinie dienen. In Weiterbildung der Erfindung ergibt sich eine besonders weitgehende Temperaturkompensation der Ausgangsspannung dadurch, dass die Diode durch einen Transistor gebildet ist, bei dem die Basis und der Kollektor miteinander verbunden sind.

Als Transistoren, die Einzeltransistoren sein können, finden vorzugsweise solche mit grosser Stromverstärkung B und hoher Transitfrequenz bei kleinem Kollektorstrom Verwendung.

Eine besonders weitgehende Verringerung der Temperaturabhängigkeit und der Auswirkung von Exemplarstreuungen auf die Ausgangsspannung lässt sich dadurch erzielen, dass die Transistoren der Emitterstufen durch einen monolithisch aufgebauten Doppeltransistor gebildet sind und/oder dass der weitere, mit dem Ausgang verbundene Transistor und der die Diode bildende Transistor durch einen Monolithisch ausgebildeten Doppeltransistor gebildet sind. Dabei ergibt sich eine besonders weitgehende Gleichtaktunterdrückung.

Die genannten vorteilhaften Eigenschaften machen den Verstärker besonders geeignet für die im Patentanspruch 5 angegebene Verwendung in einem Phasenregelkreis. Dabei lässt sich eine definierte Vergrösserung der Regelsteilheit des Phasenregelkreises erzielen, was insbesondere bei einem Phasenregelkreis in einer Taktrückgewinnungsschaltung für PCM-Regeneratoren von besonderem Vorteil sein kann. Dabei wird der dem Phasenvergleicher folgende Tiefpass durch den hohen Eingangswiderstand des Verstärkers in vorteilhafter Weise nur wenig belastet.

Die Erfindung wird anhand der in den Figuren dargestellten Ausführungsbeispiele näher erläutert.

Es zeigen

Fig. 1 einen Verstärker mit Differenzeingang und unsymmetrischem Ausgang und

Fig. 2 einen mit Strom- und Spannungspfeilen versehenen Stromlauf des Verstärkers nach Fig. 1

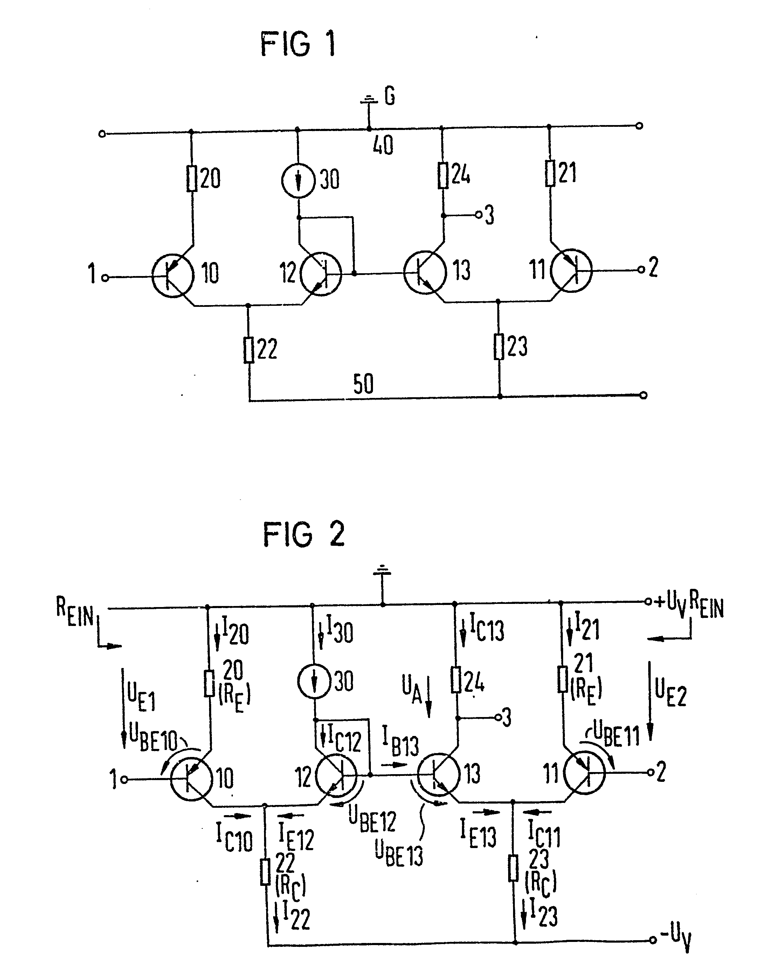

Fig. 1 zeigt einen Verstärker für eine negative Spannungsversorgung gegenüber Masse. Die Schaltung enthält zwei PNP-Eingangstransistoren, einen Transistor 10 mit nichtinvertierendem Eingang 1 sowie einen Transistor 11 mit invertierendem Eingang 2. Die Emitter dieser Transistoren 10, 11 sind über die Widerstände 20, 21 an die Massepotential-Leitung 40 gelegt, die ihrerseits auf Masse G liegt. Die Kollektoren dieser Transistoren 10, 11 sind jeweils mit den Emittern von zwei NPN-Transistoren 12 bzw. 13 verbunden und liegen über die Widerstände 22 bzw. 23 an der gegenüber Masse negativen Leitung 50 der Stromversorgung.

Die Basisanschlüsse der Transistoren 12, 13 sowie der Kollektoranschluss von Transistor 12 sind miteinander verbunden und liegen über eine Konstantstromquelle 30 an der Massepotential-Leitung 40. Der Kollektor von Transistor 13 ist über den Lastwiderstand 24, an dem das Ausgangssignal abgenommen werden kann, ebenfalls mit der Massepotential-Leitung 40 verbunden. Der Transistor 12 ist dabei als Diode geschaltet. Das Ausgangssignal liegt zwischen dem Ausgangsanschluss 3 und Masse.

Die Widerstände 22 und 23 werden zweckmässigerweise im Hinblick auf eine hohe Grenzfrequenz so gross wie möglich und so klein, wie es mit Rücksicht auf den bei gegebener Versorgungsspannung erforderlichen Spannungshub am Ausgang nötig ist, bemessen.

Fig. 2 zeigt den Stromlauf mit Strom- und Spannungspfeilen. Die Funktionsweise des Verstärkers beruht darauf, dass die Höhe der Spannungen an den Widerständen 22 und 23 bis auf minimale Unterschiede (Einfluss des Kollektor-Stromes $I_{C13}$ auf die Basis-Emitter-Spannung $U_{BE13}$ von Transistor 13) übereinstimmen. Das bedeutet, dass die Summe der Einzelströme durch die Widerstände 22, 23 mit guter Näherung gleich gross sind ($I_{C10} + I_{E12} = I_{C11} + I_{E13}$), wenn die Widerstände 20 und 21 bzw. 22 und 23 den gleichen Widerstandwert haben ($R_{20} = R_{21} = R_E$ und $R_{22} = R_{23} = R_C$).

Die Transistoren 10 und 11 bzw. 12 und 13 haben zweckmässigerweise die gleichen monolithisch aufgebaute Doppeltransistoren mit üblichen Stromverstärkungen. In diesem Fall gilt $B_{10} = B_{11} = B_{12} = B_{13} = B$ und $\beta_{10} = \beta_{11} = \beta_{12} = \beta_{13} = \beta$. Die Basis-Emitter-Spannungen sind gleich gross ($U_{BE10} = B_{BE11} = U_{BE12} = U_{BE13}$) und die Basis-Emitter-Spannungsänderungen auf Grund von Kollektor Stromänderungen sind vernachlässigbar gegenüber den wirksamen Steuerspannungsänderungen der Transistoren ($\Delta U_{BE10} = \Delta U_{BE11} = \Delta U_{BE12} = \Delta U_{BE13} = 0$).

Die Stromquelle 30 ist ein Zweipol, der als Konstantstromschaltung ausgebildet ist. Derartige Zweipole sind als solche bekannt, z.B. als sogenannte Konstantstromdioden, die aus einem Feldeffekttransistor mit Widerstand bestehen.

Derartige Stromquellen sind für den vorliegenden Fall praktisch als ideal zu betrachten, d.h. der Strom $I_{30}$ ist praktisch konstant.

Findet keine Aussteuerung des Verstärkers statt, d.h. beide Eingangspegel sind gleich hoch ($\Delta U_{E1} = \Delta U_{E2} = 0$, $U_{E1} = U_{E2}$) so ist $I_{C10} = I_{C11}$ und $I_{E13} = I_{E12}$.

Da $U_A = I_{C13} \cdot R_{24}$, $I_{E12} = I_{30} - I_{B13}$ und

$$I_{C13} \left(1 + \frac{1}{B_{13}}\right) = I_{30} - \frac{I_{C13}}{B_{13}} \text{, so ist}$$

$$I_{C13} \left(1 + \frac{2}{B_{13}}\right) = I_{30} \text{ und}$$

$$U_A = \frac{I_{30} \cdot R_{24}}{1 + \frac{2}{B_{13}}}$$

Bei den üblichen Gleichstromverstärkungen ist die Ausgangsspannung $U_A$ in erster Näherung nur abhängig von der Stromquelle 30 und dem Kollektorwiderstand 24 von Transistor 13:

$$U_A = R_{24} \cdot I_{30}$$

Findet eine Aussteuerung des Verstärkers statt, d.h. ändern sich die Kollektorströme $I_{C10}$ und $I_{C11}$ der Eingangstransistoren 10, 11 gegenphasig auf Grund von gegenphasiger Ansteuerung der Eingänge ($\Delta U_{E1} = -\Delta U_{E2}$), so ändert sich der Emitterstrom des Transistors 13 wie folgt:
$I_{E13} + \Delta I_{E13} = I_{C10} + \Delta I_{C10} - (I_{C11} + \Delta I_{C11}) + I_{E12} + \Delta I_{E12}$ $I_{E13} = I_{C10} - I_{C11} + I_{E12}$ eingesetzt ergibt:
$\Delta I_{E13} = \Delta I_{C10} - \Delta I_{C11} + \Delta I_{E12}$ wobei

$$\Delta I_{C10} = \frac{\Delta U_{E1} - U_{BE}}{R_E \left(1 + \frac{1}{\beta}\right)} \quad , \quad \Delta I_{C11} = \frac{\Delta U_{E2} - U_{BE}}{R_E \left(1 + \frac{1}{\beta}\right)}$$

$\Delta I_{E12} = -\Delta I_{B13}$ und $\Delta U_A = (\Delta I_{E13} - \Delta I_{B13}) R_{24}$
damit wird

$$\Delta U_A = \frac{R_{24} (\Delta I_{C10} - \Delta I_{C11})}{1 + \frac{2}{\beta}} \quad \text{und} \quad \Delta U_A = \frac{R_{24} (\Delta U_{E1} - \Delta U_{E2})}{R_E \left(1 + \frac{2}{\beta}\right) \cdot \left(1 + \frac{1}{\beta}\right)}$$

Durch die symmetrische Anordnung der Eingangstransistoren 10, 11 in der Schaltung, werden Einflüsse von Gleichtakt-Eingangs-Spannungsänderung ($\Delta U_{E1} = \Delta U_{E2}$) und Einflüsse von gleichartigen Parameteränderungen der entsprechenden Transistoren auf die Ausgangsspannung unterdrückt. Ebenfalls haben Spannungsänderungen der Basis-Emitter-Strecken auf Grund von Temperatureinflüssen $\Delta T$ an den Transistoren 10, 11, 12, 13 durch den symmetrischen Aufbau der Schaltung keinen Einfluss auf die Ausgangsspannung $U_A$. Zusätzlich ist die Ausgangsspannung $U_A$ in weiten Grenzen unabhängig von Versorgungsspannungs-Schwankungen $\Delta U_V$.

Die Verstärkung v bei gegenphasiger Aussteuerung beträgt unter den genannten Voraussetzungen

$$v = \frac{\Delta U_A}{\Delta U_{E1} - \Delta U_{E2}}$$

$$v = \frac{R_{24}}{R_E}$$

und ist damit nur abhängig von dem Verhältnis der Widerstände $R_{24}$ und $R_{20}$, $R_{21}$, aber nahezu unabhängig von Temperaturschwankungen $\Delta T$ und Versorgungsspannungs-Schwankungen $\Delta U_V$.

Der Eingangswiderstand $R_{Ein}$ der Schaltung kann in etwa mit $R_{Ein} = h_{11E} + h_{21E} \cdot R_E$ angegeben werden. Da $h_{11E} << h_{21E} \cdot R_E$ ist, so ist $R_{Ein} \approx R_E \cdot \beta$ und damit sehr hochohmig.

Die gleichen Eigenschaften hat eine Schaltung für positive Spannungsversorgung mit Transistoren des anderen Leitungstyps. In diesem Fall sind die beiden Eingangstransistoren 10 und 11 vom Typ NPN und die Transistoren 12 und 13 vom Typ PNP. Die Leitung 50 führt in diesem Fall positives Potential.

Anhang: Allgemeine Ableitung der Formeln.

Nach Fig. 2 können folgende Gleichungen aufgestellt werden:

$$U_{BE12} + R_{22}I_{22} = U_{BE13} + R_{23}I_{23} \qquad 1$$

$$I_{22} = I_{C10} + I_{C12} \left( 1 + \frac{1}{B_{12}} \right) \qquad 2$$

$$I_{23} = I_{C11} + I_{C13} \left( 1 + \frac{1}{B_{13}} \right) \qquad 3$$

$$I_{C10} = \frac{I_{20}}{1 + \frac{1}{B_{10}}} \qquad 4$$

$$I_{C11} = \frac{I_{21}}{1 + \frac{1}{B_{11}}} \qquad 5$$

$$I_{C12} = \frac{I_{30} - \frac{I_{C13}}{B_{13}}}{1 + \frac{1}{B_{12}}} \qquad 6$$

$$I_{20} = \frac{U_{E1} - U_{BE10}}{R_{20}} \qquad 7$$

$$I_{21} = \frac{U_{E2} - U_{BE11}}{R_{21}} \qquad 8$$

$$I_{C13} = \frac{U_A}{R_{24}} \qquad 9$$

Gleichungen 2 bis 9 in Gleichung 1 eingesetzt ergibt:

$$U_{BE12} + R_{22} \left[ \frac{U_{E1} - U_{BE10}}{R_{20} \left( 1 + \frac{1}{B_{10}} \right)} + I_{30} \right] - \frac{R_{22} \cdot U_A}{R_{24} \cdot B_{13}} = U_{BE13} + R_{23} \left[ \frac{U_{E2} - U_{BE11}}{R_{21} \left( 1 + \frac{1}{B_{11}} \right)} \right] +$$

$$\frac{R_{23} \cdot U_A}{R_{24}} \left( 1 + \frac{1}{B_{13}} \right). \qquad 10$$

Gleichung 10 nach $U_A$ aufgelöst ergibt:

$$U_A = \frac{U_{BE12} - U_{BE13} + R_{22} \left[ \frac{U_{E1} - U_{BE10}}{R_{20} \left( 1 + \frac{1}{B_{10}} \right)} + I_{30} \right] - R_{23} \left[ \frac{U_{E2} - U_{BE11}}{R_{21} \left( 1 + \frac{1}{B_{11}} \right)} \right]}{\frac{R_{23}}{R_{24}} \left( 1 + \frac{1}{B_{13}} \right) + \frac{R_{22}}{R_{24} \cdot B_{13}}} \qquad 11$$

Der weiteren Betrachtung wird die folgende Bemessung zugrunde gelegt:

$U_{E1} = U_{E2}$, $R_{20} = R_{21} = R_E$, $R_{22} = R_{23} = R_C$, $B_{10} = B_{11} = B$. $B >> 1$; $\beta >> 1$

Ferner ist $U_{BE} = U_T \ln \left( \frac{I_C}{I_s} + 1 \right)$. Wenn $I_{C10} + I_{C11}$ und $I_{C12} + I_{C13}$, dann ist $U_{BE10} = U_{BE11}$ und $U_{BE12} = U_{BE13}$.

Ferner ändert sich die Basis-Emitter-Spannung bei konstantem Basisstrom sehr wenig mit der Kollektor-Emitter-Spannung.

$\Delta U_{BE} \approx 10^{-5} \cdot \Delta U_{CE}$  $I_B$ = konst. und damit ist auch $U_{Be12} \approx U_{BE13}$

Weiterhin ändert sich die Basis-Emitter-Spannung der Transistoren mit der Temperatur.

$$\frac{\Delta U_{BE}}{\Delta T} = -2 \frac{mV}{K} + 0{,}3 \frac{mV}{K} \cdot 1g \frac{I_C}{100\,\mu A} \qquad 12$$

(U. Tietze, Ch. Schenk: Halbleiter-Schaltungstechnik, 3. Auflage, 1974, Seiten 25, 26 und 73)

Durch den symmetrischen Aufbau des Verstärkers kompensieren sich die Einflüsse der Temperatur auf die Basis-Emitter-Spannung.

1. Wird der Verstärker nicht ausgesteuert, so gilt: $\Delta U_{E1} = \Delta U_{E2}$

Aus Gleichung 11 wird dann

$$U_A = \frac{R_{24}}{R_E} (U_{E1}-U_{E2} + I_{30} \cdot R_E) \qquad 13$$

und wenn $U_{E1} = U_{E2}$, dann ist:

$$U_A = R_{24} \cdot I_{30}$$

2. Wird der Verstärker ausgesteuert, so gilt:

$$\Delta U_{E1} = -\Delta U_{E2}$$
$$\Delta U_{BE10} = -\Delta U_{BE11}$$

Bei den Eingangstransistoren 10, 11 ist die Basis-Emitter-Spannung $U_{BE}$ abhängig von dem Kollektorstrom $I_C$ und damit von der Eingangsspannung $U_{E1}$ bzw. $U_{E2}$.

Für den Transistor 10 gilt bei Raumtemperatur:

$$I_{C10} = I_S (e^{\frac{U_{BE10}}{U_T}} - 1) \qquad U_{E1} = U_{BE10} + R_{20} \cdot I_{C10}$$

Bei Raumtemperatur gilt: $I_S \approx 1 \cdot 10^{-15}$ A, $U_T = \frac{k \cdot T}{e_o} \approx 0{,}026$ V

$$U_{E1} + \Delta U_{E1} = U_{BE10} + \Delta U_{BE10} + R_{20} I_S (e^{\frac{U_{BE10} + \Delta U_{BE10}}{U_T}} - 1) \qquad 15$$

Wenn $\frac{U_{BE10}}{U_T} > 10$ dann gilt:

$$U_{E1} + \Delta U_{E1} = U_{BE10} + \Delta U_{BE10} + R_{20} \cdot I_S \cdot e^{\frac{U_{BE10} + \Delta U_{BE10}}{U_T}} \qquad 16$$

$$U_{E1} + \Delta U_{E1} = U_{BE10} + \Delta U_{BE10} + R_{20} \cdot I_S \cdot e^{\frac{U_{BE10}}{U_T}} \cdot e^{\frac{\Delta U_{BE10}}{U_T}} \qquad 17$$

Ist $\frac{\Delta U_{BE10}}{U_T} \leq 0{,}5$ dann kann Gleichung 17 umgeformt werden in:

$$U_{E1} + \Delta U_{E1} = U_{BE10} + \Delta U_{BE10} + R_{20} \cdot I_S \cdot e^{\frac{U_{BE10}}{U_T}} + \frac{R_{20} \cdot I_S \cdot \Delta U_{BE10}}{U_T} \cdot e^{\frac{U_{BE10}}{U_T}} \qquad 18$$

$$\Delta U_{E1} = \Delta U_{BE10} (1 + \frac{R_{20} \cdot I_S}{U_T} \cdot e^{\frac{U_{BE10}}{U_T}}) \qquad 19$$

$$\Delta U_{E1} = \Delta U_{BE10} (1 + \frac{R_{20} \cdot I_{C10}}{U_T}) \qquad 20$$

$$\Delta U_{BE10} = \frac{\Delta U_{E1}}{1 + \frac{R_{20} \cdot I_{C10}}{U_T}} \qquad \text{und damit ist} \qquad \Delta U_{BE11} = \frac{\Delta U_{E2}}{1 + \frac{R_{21} \cdot I_{C11}}{U_T}}$$

Auch bei kleinen Kollektorströmen $I_{C10}$ bzw. $I_{C11}$ ist $\Delta U_{BE10} << \Delta U_{E1}$ bzw. $\Delta U_{BE11} << \Delta U_{E2}$ und daher vernachlässigbar in ihrem Einfluss auf die Steuerspannung der beiden Steuertransistoren, wenn die Widerstandsverhältnisse $\frac{R_{20}}{R_{22}}$ bzw. $\frac{R_{21}}{R_{23}}$ in Richtung hoher Eigengegenkopplung der Eingangstransistoren gewählt werden.

$$\Delta U_{BE13} = U_T \left[ -\ln \left( \frac{I_{C13}}{I_s} + 1 \right) + \ln \left( \frac{I_{C13} + \Delta I_{C13}}{I_s} + 1 \right) \right] = U_T \ln \left( 1 + \frac{\Delta I_{C13}}{I_{C13}} \right) \qquad 21$$

$\Delta U_{BE13} << U_{BE13}$
und daher vernachlässigbar.
Es ist $\Delta U_{BE12} << \Delta U_{BE13}$ da $\Delta I_{C12} << \Delta I_{C13}$
und damit kann die Gleichung 11 erweitert werden:

$$U_A + \Delta U_A = \frac{U_{BE12} + \Delta U_{BE12} - (U_{BE13} + \Delta U_{BE13}) + R_{22} \left[ \frac{U_{E1} + \Delta U_{E1} - U_{BE10} - \Delta U_{BE10}}{R_{20}} + I_{30} \right]}{\frac{R_{23}}{R_{24}}}$$

$$-\frac{\frac{R_{23}}{R_{21}} (U_{E2} + \Delta U_{E2} - U_{BE11} - \Delta U_{BE11})}{\frac{R_{23}}{R_{24}}} \qquad 20$$

$$\Delta U_A = \frac{R_{24}}{R_E} (\Delta U_{E1} - \Delta U_{E2}) \qquad 24$$

Gleichung 11 in Gleichung 22 eingesetzt ergibt:

$$v = \frac{\Delta U_A}{\Delta U_{E1} - \Delta U_{E2}} \qquad 25$$

$$\Delta U_A = \frac{\frac{R_{22} \cdot \Delta U_{E1}}{R_{20}} - \frac{R_{23} \cdot \Delta U_{E2}}{R_{21}}}{\frac{R_{23}}{R_{24}}} \qquad 25$$

$$v = \frac{R_{24}}{R_E} \qquad 26$$

Die Verstärkung hängt somit in vorteilhafter Weise nur vom Verhältnis zweier Widerstände ab.

## Patentansprüche

1. Verstärker mit gleichspannungsgekoppelten Transistorstufen, mit einem Differenzeingang und mit einem unsymmetrischen, mit einem Anschluss an einem Bezugspotential liegenden Ausgang, wobei die Anschlüsse (1, 2) des Differenzeinganges mit den Basisanschlüssen von zwei Transistoren (10, 11) des gleichen Leitfähigkeitstyps verbunden sind und von einem weiteren Transistor (13), der mit den am Differenzeingang liegenden Transistoren (10, 11) gleichstrommässig gekoppelt ist und dessen Leitfähigkeitstyp dem der am Differenzeingang liegenden Transistoren (10, 11) entgegengesetzt ist, der Kollektor den anderen Anschluss des unsymmetrischen Ausgangs (3, G) des Verstärkers bildet, der Emitter direkt an einer Ausgangselektrode des Transistors (11) einer der Emitterstufen liegt und die Basis am Verbindungspunkt einer Diode und eines als Konstantstromschaltung ausgebildeten und an das Bezugspotential geführten Zweipols liegt, dadurch gekennzeichnet, dass die am Differenzeingang liegenden Transistoren (10, 11) jeweils als Emitterstufe mit einem Arbeitswiderstand (22, 23) in der Kollektorzuführung und mit je einem Stromgegenkopplungswiderstand (20, 21) in der Emitterzuführung geschaltet sind und dass der Verbindungspunkt der Stromgegenkopplungswiderstände an dem Bezugspotential liegt und dass der Kollektor des weiteren Transistors (13) über einen Widerstand (24) an das Bezugspotential (G)

geführt ist und dass die Ausgangselektrode des Transistors (11) der einen Emitterstufe, mit der Emitter des weiteren Transistors (13) verbunden ist, der Kollektor des Transistors (11) ist und dass die Diode (12), mit der die Basis des weiteren Transistors (13) verbunden ist, an den Kollektor des Transistors (10) der anderen Emitterstufe geführt ist.

2. Verstärker nach Anspruch 1, dadurch gekennzeichnet, dass die Diode durch einen Transistor (12) gebildet ist, bei dem die Basis und der Kollektor miteinander verbunden sind.

3. Verstärker nach Anspruch 1, dadurch gekennzeichnet, dass die Transistoren (10, 11) der Emitterstufen durch einen monolithisch aufgebauten Doppeltransistor gebildet sind.

4. Verstärker nach Anspruch 2, dadurch gekennzeichnet, dass der weitere, mit dem Ausgang (3) verbundene Transistor (13) und der die Diode bildende Transistor (12) durch einen monolithisch ausgebildeten Doppeltransistor gebildet sind.

5. Verstärker nach einem der Ansprüche 1 bis 4, gekennzeichnet durch die Verwendung des Verstärkers als Regelverstärker in einem einen Oszilator und einen Phasenvergleicher enthaltenden Phasenregelkreis, derart, dass der Verstärker mit seinem Differenzeingang am Ausgang eines an den Phasenregelkreis angeschlossenen Tiefpasses liegt und mit seinem Ausgang an einen Steuereingang des Oszillators geführt ist.

## Revendications

1. Amplificateur à étages à transistors couplés en tension continue avec une entrée différentielle et avec une sortie dissymmétrique à une borne portée à un potentiel de référence, les bornes (1 et 2) de l'entrée différentielle étant reliées aux bornes de base de deux transistors (10, 11) d'un même type de conductivité, alors que le collecteur d'un autre transistor (13), qui est couplé en courant continu aux transistors (10, 11) reliés à l'entrée différentielle et dont le type de conductivité est opposé à celui des transistors (10, 11) reliés à l'entrée différentielle, forme l'autre borne de la sortie dissymmétrique (3, G) de l'amplificateur; l'émetteur étant relié directement à une électrode de sortie du transistor (11) de l'un des étages d'émetteurs et la base étant reliée au point de liaison entre une diode et un dipôle réalisé sous la forme d'un circuit de courant constant et porté au potentiel de référence, caractérisé par le fait que chacun des transistors (10, 11) relié à l'entrée différentielle est monté en tant qu'étage d'émetteur, et avec une résistance de chute (22, 23) dans le conducteur d'amenée, et avec respectivement une résistance de contre-réaction de courant (20, 21), dans le conducteur d'amenée d'émetteurs et que le point de liaison des résistances de contre-réaction de courant est porté au potentiel de référence et que le collecteur dudit autre transistor (13) est porté, par l'intermédiaire d'une résistance (24), au potentiel de référence (G), et que l'électrode de sortie du transistor (11) de l'un des étages d'émetteur, avec laquelle est relié l'émetteur dudit autre transistor (13), est le collecteur du transistor (11), et que la diode (12) avec laquelle est reliée la base dudit autre transistor (13), est reliée au collecteur du transistor de l'autre étage d'émetteur.

2. Amplificateur selon la revendication 1, caractérisé par le fait que la diode est constituée par un transistor (12) dans lequel la base et le collecteur sont reliés entre eux.

3. Amplificateur selon la revendication 1, caractérisé par le fait que les transistors (10, 11) des étages d'émetteur sont constitués par un transistor double de construction monolithique.

4. Amplificateur selon la revendication 2, caractérisé par le fait que ledit autre transistor (13) qui est relié à la sortie (3) et le transistor (12) qui constitue la diode, sont constitués par un transistor double réalisé de façon monolithique.

5. Amplificateur selon l'une des revendications 1 à 4, caractérisé par la mise en œuvre de l'amplificateur comme amplificateur de réglage dans un circuit de réglage de phase qui comporte un oscillateur et un comparateur de phase, et cela de telle façon que l'amplificateur est relié par son entrée différentielle à la sortie d'un passe-bas relié au circuit de réglage de phase et qu'il est relié, par sa sortie, à une entrée de commande de l'oscillateur.

## Claims

1. An amplifier with d.c.-coupled transistor stages, having a differential input, and as asymetrical output having one terminal connected to a reference potential, where the terminals (1, 2) of the differential input are connected to the respective base terminals of two transistors (10, 11) of the same conductivity type, and a further transistor (13) is d.c.-coupled to the transistors (10, 11) connected to the differential inputs, whose conductivity type is opposed to that of the transistors (10, 11) connected to the differential inputs, the collector of which forms the other terminal of the asymetrical ouptut (3, G) of the amplifier, its emitter being directly connected to an output electrode of the transistor (11), connected as an emitter stage, and the base of which is connected to the connection point between a diode and a two-terminal network which represents a constant current source and leads to the reference potential, characterised in that the transistors (10, 11) connected to the differential inputs are each connected as emitter stages, with an operating resistor (22, 23) in the collector supply lines and a negative current feedback resistor (20, 21) in the emitter supply lines, and that the connection point of the negative current feedback resistors is connected to the reference potential and that the collector of the further transistor (13) leads via a resistor (24) to the reference potential (G), and that the output electrode of the transistor (11) of the first emitter stage, to which the emitter of the further transistor (13) is connected, is the collector of the transistor (11), and that the diode (12), to which the base of the further transistor (13) is connected, leads to the collector of the transistor (10) of the other emitter stage.

2. An amplifier as claimed in Claim 1, characterised in that the diode is formed by a transistor (12) having its base and collector connected together.

3. An amplifier as claimed in Claim 1, characterised in that the transistors (10, 11) of the emitter stages are formed by a double transistor of monolithic construction.

4. An amplifier as claimed in Claim 2, characterised in that the further transistor (13) connected to the output (3), and the transistor (12) which serves as the diode are formed by a double transistor of monolithic construction.

5. An amplifier as claimed in one of Claims 1 to 4, characterised by the use of the amplifier as a regulating amplifier in a phase-regulating circuit which contains an oscillator and a phase comparator, in such manner that the amplifier is connected by its differential input to the output of a low-pass filter connected to the phase-regulating circuit, and that its output leads to a control input of the oscillator.

## FIG 1

## FIG 2